# EUROPEAN PATENT APPLICATION

(11) **EP 2 043 160 A2**
(43) Date of publication of application: **01.04.2009**
(21) Application number: 08017084.8
(22) Date of filing: 29.09.2008
(51) Int. Cl.: H01L 31/02, H01L 31/042

(54) **Universal interface for a photovoltaic module**

(30) Priority: 28.09.2007 US 976369 P
(71) Applicant: Enphase Energy, Inc., Petaluma CA (US)
(72) Inventor: Fornage, Martin, Petaluma, CA 94952 (US); Meeker, Matthew Kengi, Santa Rosa, CA 95404 (US)
(74) Representative: Jackson, Derek Charles

(57) **Abstract**

An apparatus for providing a universal interface (112) for a photovoltaic (PV) module (102). The apparatus comprises a universal retainer plate for mechanically coupling an output power module (114) to the PV module (102).
Such an interface allows the output power module (114) to easily be coupled to and/or decoupled from the PV module (102) during manufacturing and/or in a field environment, thereby providing flexibility for replacing failed output power modules or changing the type of output power module as needed.

## Description

### CROSS-REFERENCE TO RELATED APPLICATIONS

This application claims benefit of United States provisional patent application serial number 60/976,369, filed September 28, 2007, which is herein incorporated by reference.

### BACKGROUND OF THE INVENTION

### Field of the Invention

Embodiments of the present disclosure generally relate to an apparatus for providing a universal interface for a photovoltaic (PV) module. The apparatus comprises a universal retainer plate for mechanically coupling an output power module to the PV module.

### Description of the Related Art

Solar panels have historically been deployed in mostly remote applications, such as remote cabins in the wilderness or satellites, where commercial power was not available. Due to the high cost of installation, solar panels were not an economical choice for generating power unless no other power options were available. However, the worldwide growth of energy demand is leading to a durable increase in energy cost. In addition, it is now well established that the fossil energy reserves currently being used to generate electricity are rapidly being depleted. These growing impediments to conventional commercial power generation make solar panels a more attractive option to pursue.

Solar panels, or photovoltaic (PV) modules, convert energy from sunlight received into direct current (DC). The PV modules cannot store the electrical energy they produce, so the energy must either be dispersed to an energy storage system, such as a battery or pumped hydroelectricity storage, or dispersed by a load. In some cases, PV modules may be coupled to inverters that invert the generated DC current into an alternating current (AC). The inversion occurs in two stages: the first stage performs a DC-DC conversion and the second stage performs a DC-AC inversion. The DC-AC inverter may be distributed (i.e., a plurality of inverters for a plurality of PV modules), or centralized (i.e. one inverter for a plurality of PV modules). Further, in a distributed inverter system, the first stage may be distributed and the second stage centralized, or both stages may be distributed. The resulting AC power can then be utilized to drive devices, such as home appliances, and/or coupled to a commercial power grid to sell the generated power to the commercial power company. Alternatively, PV modules may be coupled to DC junction boxes comprising a plurality of diodes to control the output power from the panel and generate a DC output.

Although PV modules may be used for providing AC or DC power, current configurations of PV modules do not provide the flexibility such that a DC-AC inverter, a DC-DC converter, or a DC junction box can be interchangeably coupled to the PV module or easily detached once coupled to the PV module. For example, a DC junction box may be permanently adhered to a PV module during manufacturing, and thus cannot be easily removed from the PV module or interchanged for a DC-AC inverter.

Therefore, there is a need in the art for an apparatus to provide a universal interface for a PV module.

### SUMMARY OF THE INVENTION

Embodiments of the present invention generally relate to an apparatus for providing a universal interface for a photovoltaic (PV) module. The apparatus comprises a universal retainer plate for mechanically coupling a DC-AC inverter, a DC-DC converter, or a DC junction box to the PV module.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 is a block diagram of a system for power generation in accordance with one or more embodiments of the present invention; and

Figure 2 is an exploded, perspective view of an assembly comprising a PV module, a set of conductive terminals, a heat spreader, a universal interface, and two types of an output power module in accordance with one or more embodiments of the present invention.

### DETAILED DESCRIPTION

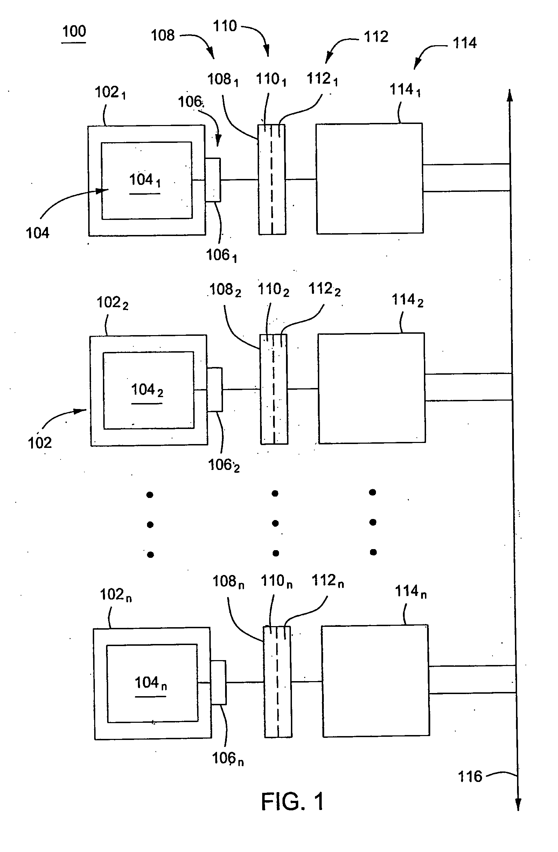

Figure 1 is a block diagram of a system 100 for power generation in accordance with one or more embodiments of the present invention. This diagram only portrays one variation of the myriad of possible system configurations. The present invention can function in a variety of environments and systems.

The system 100 comprises a plurality of PV modules 102₁, 102₂, ..., 102ₙ, where each PV module 102₁, 102₂, ..., 102ₙ comprises a PV cell array 104₁, 104₂, ..., 104ₙ, respectively, for transforming solar energy received from the sun into a DC current. Each PV cell array 104₁, 104₂, ..., 104ₙ is coupled to a set of conductive terminals 106₁, 106₂, ..., 106ₙ, respectively, via electrodes that provide the generated DC current to the sets of conductive terminals 106₁, 106₂, ..., 106ₙ. The PV modules 102₁, 102₂, ..., 102ₙ, PV cell arrays 104₁, 104₂, ..., 104ₙ, and sets of conductive terminals 106₁, 106₂, ..., 106ₙ are collectively referred to as PV modules 102, PV cell arrays 104, and set of conductive terminals 106, respectively.

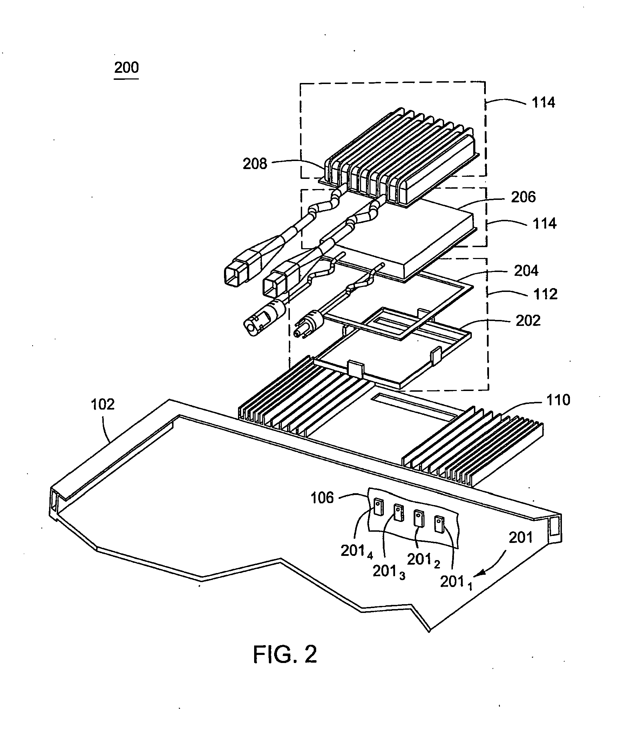

In one or more embodiments, each PV cell array 104 comprises three groupings of twenty-four PV cells (not shown) coupled in series for generating the DC current, and couples such DC current to the set of conductive terminals 106 via four electrodes. Additionally, in one or more embodiments, each of the four electrodes may be coupled to an individual terminal in the set of conductive terminals 106, as further described below in relation to Figure 2.

The power generation system 100 further comprises a plurality of interfaces 108₁, 108₂, ...., 108ₙ, collectively referred to as interfaces 108. Each of the interfaces 108 is coupled to a PV module 102 in a one-to-one correspondence. Additionally, a plurality of output power modules 114₁, 114₂, ..., 114ₙ, collectively referred to as output power modules 114, are coupled to the sets of conductive terminals 106 in a one-to-one correspondence, via the interfaces 108.

In one embodiment of the invention, the interfaces 108 comprise a heat spreader 110₁, 110₂, ..., 110ₙ, and a universal interface 112₁, 112₂, ..., 112ₙ, collectively referred to as heat spreaders 110 and universal interfaces 112, respectively. In some embodiments, the heat spreaders 110 may be integral to the universal interfaces 112; alternatively, the heat spreaders 110 may be separate from the universal interfaces112. The heat spreaders 110 minimize the temperature excursions around the universal interfaces 112 by increasing the heat dissipation and equalizing the temperature of the PV cells by conduction, thereby maintaining a uniform thermal profile across the temperature-sensitive PV cells of the PV modules 102. Such temperature equalization of the PV cells ensures that the universal interfaces 112 do not limit the heat dissipation of the PV cells proximate the universal interfaces 112, which would cause the PV cells to operate at different temperatures and negatively impact the power production of the PV modules 102.

Each output power module 114 couples power generated by the PV modules 102 to a bus 116 via two output interfaces. In some embodiments, the output power modules 114 are DC-AC inverters that invert the DC power generated by the PV modules 102 to a two-terminal AC power output. Such DC-AC inverters may be micro-inverters. In alternative embodiments, the output power modules 114 are DC junction boxes comprising a plurality of diodes to control the DC power generated by the PV modules 102 and produce a two-terminal DC output. In a further embodiment, the output power modules 114 are DC-DC converters that increase or decrease the DC voltage from the PV modules 102 and supply the voltage to a two-terminal DC output. In each embodiment, the output power modules 114 have a form factor mountable to the interfaces 108.

The universal interfaces 112 provide an interface capability for coupling the output power modules 114 to the PV modules 102 such that modules may later be de-coupled from the PV modules 102 as needed. Such an interface allows the output power modules 114 to easily be coupled to and/or de-coupled from the PV modules 102 during manufacturing and/or in a field environment, thereby providing flexibility for replacing failed output power modules 114 or changing the type of output power module 114 as needed.

Figure 2 is an exploded, perspective view of an assembly 200 comprising a PV module 102, a set of conductive terminals 106, a heat spreader 110, a universal interface 112, and two types of an output power module 114 in accordance with one or more embodiments of the present invention.

In some embodiments, the set of conductive terminals 106 is mounted to the rear of the PV module 102. In some embodiments, the set of conductive terminals 106 comprises four "quick connect" terminals 201₁, 201₂, 201₃, and 201₄, collectively referred to as conductive terminals 201, where each of the conductive terminals 201 is coupled to an individual electrode from the PV cell 104. Alternative embodiments may comprise fewer or more conductive terminals 201. The conductive terminals 201 may be coupled to the output power module 114 to provide the DC current generated by the PV module 102. Additionally, some of the conductive terminals 201 may support internal bypass diodes of the PV module 102; such internal bypass diodes prevent PV cell reverse voltage breakdown during particularly low solar irradiance conditions.

The heater spreader 110 is generally adhered to the PV module 102 using an adhesive; alternatively, the heat spreader 110 may not be directly coupled to the PV module 102. The heat spreader 110 may be fabricated from any thermally conductive material, such as plastic, metal, and the like. In some embodiments, the architecture of the heat spreader 110 may include a series of heat dissipating "fins", as depicted in Figure 2.

The universal interface 112 comprises a universal retainer plate 202. In some embodiments, the universal retainer plate 202 is integral to the heat spreader 110; alternatively, the universal retainer plate 202 may be a separate element (as depicted in Figure 2) and adhered to the heat spreader 110. Alternatively, the universal retainer plate 202 may be permanently adhered to the set of conductive terminals 106. The universal retainer plate 202 comprises one or more flat strips that act as "clips" to mechanically couple the output power module 114 to the universal interface 112 such that the output power module 114 may later be de-coupled from the universal interface 112 as needed. Additionally, the universal interface 112 comprises an environmental sealing gasket 204 that is retained between the universal retainer plate 202 and the output power module 114. The environmental sealing gasket 204 protects the unit from the environment and provides a thermal barrier between the PV module 102 and the output power module 114.

In some embodiments, the output power module 114 comprises a DC-AC inverter 206, where the inverter 206 may be a micro-inverter type of inverter. In some embodiments, the output power module 114 comprises a DC junction box 208. In some embodiments, the output power module 114 comprises a DC-DC converter (not shown). The universal interface 112 allows for the DC-AC inverter 206, the DC junction box 208, or the DC-DC converter to be coupled to the PV module 102 and detached as needed. Additionally, such coupling may take place either in a manufacturing environment or in a field environment. The universal interface 112 facilitates flexible solar system design and fabrication by allowing a PV module to be used with a variety of different output power modules.

While the foregoing is directed to embodiments of the present invention, other and further embodiments of the invention may be devised without departing from the basic scope thereof, and the scope thereof is determined by the claims that follow.

## Claims

1. An apparatus for providing a universal interface for a photovoltaic (PV) module, comprising a universal retainer plate for mechanically coupling an output power module to the PV module.

2. The apparatus of claim 1 wherein the output power module comprises at least one of a DC-AC inverter having a form factor mountable to the universal retainer plate, a DC-DC converter having the form factor, or a DC junction box having the form factor.

3. The apparatus of claim 1 further comprising at least one conductive terminal mounted to the PV module and the at least one conductive terminal is capable of being detachably coupled to the output power module.

4. The apparatus of claim 3 wherein the at least one conductive terminal is permanently adhered to the universal retainer plate.

5. The apparatus of claim 1 wherein the universal retainer plate comprises at least one fastening device for mechanically coupling the output power module to the PV module.

6. The apparatus of claim 5 wherein the at least one fastening device is a clip.

7. The apparatus of claim 1 further comprising a sealing gasket retained between the universal retainer plate and the output power module.

8. The apparatus of claim 1 wherein the output power module is detachably coupled to the universal retainer plate.

9. An apparatus for dissipating heat generated at a photovoltaic (PV) module, comprising:
a universal retainer plate for mechanically coupling an output power module to the PV module; and
a heat spreader retained between the PV module and the output power module for providing a uniform thermal profile across the PV module.

10. The apparatus of claim 9 wherein the heat spreader is adhered to the PV module.

11. The apparatus of claim 9 wherein the heat spreader comprises heat dissipating fins.

12. The apparatus of claim 9 wherein the heat spreader is integral to the universal retainer plate.
